# EUROPEAN PATENT SPECIFICATION

(11) **EP 2 236 642 B1**
(45) Date of publication and mention of the grant of the patent: **21.06.2017**
(21) Application number: 10250669.8
(22) Date of filing: 31.03.2010
(51) Int. Cl.: C23C 14/02, C23C 14/08, C23C 8/12, C23C 8/02, C23C 28/00, C23C 14/56

(54) **CONTROLLED OXIDATION OF BOND COAT**
GESTEUERTE OXIDATION EINER HAFTBESCHICHTUNG
OXYDATION CONTRÔLÉE D'UNE COUCHE DE LIAISON

(30) Priority: 31.03.2009 US 415030
(43) Date of publication of application: 06.10.2010
(73) Proprietor: United Technologies Corporation, Farmington, CT 06032 (US)
(72) Inventor: Latour, Robert F., Bolton Connecticut 06043 (US); Neal, James W., Ellington Connecticut 06029 (US)
(74) Representative: Hall, Matthew Benjamin

(56) References cited:
- EP-A1- 1 746 185
- US-A1- 2004 211 363
- NIJDAM T J ET AL: "Development of a Pre-Oxidation Treatment to Improve the Adhesion between Thermal Barrier Coatings and NiCoCrAlY Bond Coatings" OXIDATION OF METALS, KLUWER ACADEMIC PUBLISHERS-PLENUM PUBLISHERS, NE LNKD- DOI:10.1007/S11085-006-9036-8, vol. 66, no. 5-6, 28 November 2006 (2006-11-28), pages 269-294, XP019453210 ISSN: 1573-4889

## Description

This disclosure relates to coatings and, more particularly, to a method for forming a strong bond between a ceramic coating and a substrate.

Gas turbine engine components, such as turbine blades, turbine vanes, or the like, may be fabricated from superalloy materials. However, under the extreme conditions found in gas turbine engines, even superalloys may benefit from protective coatings to limit corrosion, oxidation, and the like. For instance, the protective coating may be a ceramic coating that functions as a thermal barrier, erosion barrier, or both.

Typically, a bond coat is used between the ceramic coating and the superalloy substrate to facilitate strong bonding. Although effective, portions of the ceramic coating may spall after extended periods of use in the engine and require repair or cause the component to be replaced.

EP 1 746 185 A1 discloses a method for providing a thermal barrier coating wherein the coating is provided on a thermally grown oxide which is grown on a metallic bond coating provided on the substrate.

According to the present invention there is provided a method of processing an article which includes heating the article using graphite heating elements in a low pressure atmosphere that is substantially free of oxygen to an oxidation temperature above about 1800°F (982°C). The article includes a substrate and a bond coat comprising MCrAlY disposed on the substrate, A partial pressure of oxygen is established after heating to the oxidation temperature such that the low pressure atmosphere is at a pressure no greater than 0,1 torr (0.067 - 13.3 pascals). At least a portion of the bond coat oxidizes for a time of fifteen minutes or less in the partial pressure of oxygen at the oxidation temperature to form alpha-alumina to the substantial exclusion of forming other types of alumina. A ceramic coating is then deposited on the oxide.

There is also disclosed herein an exemplary article which is fabricated using such methods and includes a substrate, a bond coat disposed on the substrate and a ceramic coating disposed on the bond coat. The bond coat includes MCrAlY and at least a portion of the aluminum of the MCrAlY is in the form of alpha-alumina.

Certain preferred embodiments of the present invention will now be described in greater detail, by way of example only, and with reference to the accompanying drawings, in which:
Figure 1 illustrates an example article having a substrate, a bond coat with a thermally grown oxide, and a ceramic coating;
Figure 2 illustrates an example method for processing the article shown in Figure 1; and
Figure 3 illustrates an example coating device for processing the article shown in Figure 1.

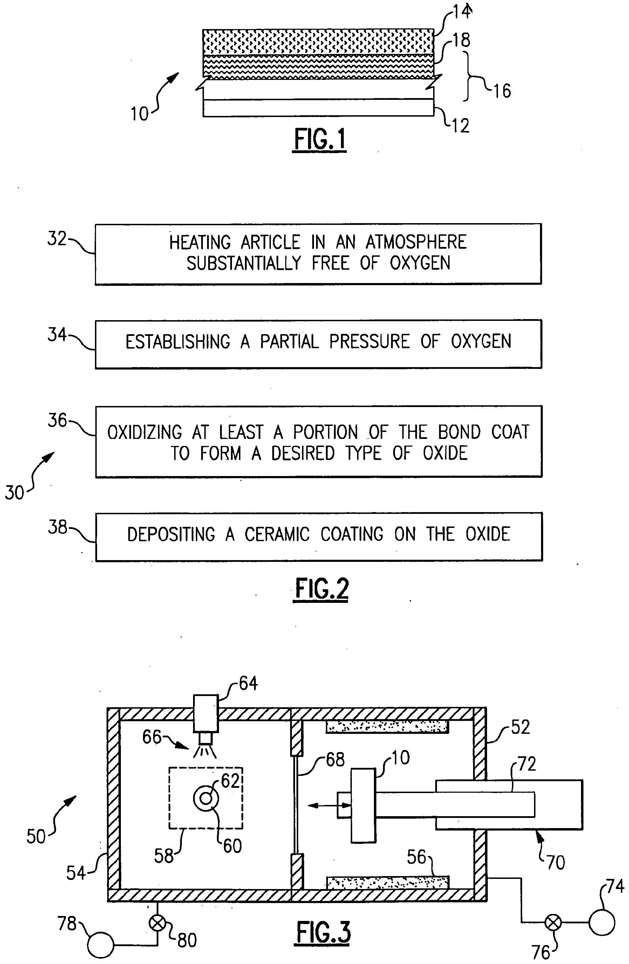

Figure 1 illustrates selected portions of an example article 10. For instance, the article 10 may be a portion of a gas turbine engine component or other type of component that is generally subjected to severe environmental conditions in terms of heat, corrosivity, and the like. For instance, the article 10 may be a gas turbine engine vane.

The article 10 includes a substrate 12, a ceramic coating 14, and a bond coat 16 between the substrate 12 and the ceramic coating 14. In this case, a portion of the bond coat 16 near the ceramic coating 14 is oxidized as alpha-alumina 18. The alpha-alumina 18 facilitates strong bonding between the ceramic coating 14 and the substrate 12 to reduce spalling of the ceramic coating 14.

The alpha-alumina 18 has a hexagonal crystallographic microstructure, which the inventors have found provides strong bonding between the ceramic coating 14 and the substrate 12 compared to other types of alumina. For instance, gamma-alumina has a cubic structure and kappa-alumina has an orthorhombic structure, neither of which provides strong bonding. In the disclosed example, substantially all of the alumina of the bond coat 16 may be alpha type to promote strong bonding and reduce spallation compared to articles having no oxide or other forms of alumina.

The type of material selected for the substrate 12 may depend on the intended use of the article 10. As an example, the substrate 12 may be formed of a superalloy material, such as a nickel-based alloy or cobalt-based alloy.

Likewise, the type of bond coat 16 selected may depend on the intended use of the article 10. As an example, the bond coat 16 may be MCrAlY, where the M is selected from cobalt, nickel, iron, or combinations thereof, the Cr is chromium, the Al is aluminum, and the Y is yttrium.

The ceramic selected for the ceramic coating 14 may also depend on the article 10. As an example, the ceramic coating 14 may include gadolinia stabilized zirconia, yttria stabilized zirconia, or combinations thereof. Given this description, one of ordinary skill in the art will recognize other types of superalloys, bond coats 16, or ceramic coatings 14 to meet their particular needs.

Figure 2 illustrates an example method 30 for fabricating the article 10. The method 30 includes a heating step 32, a pressurizing step 34, an oxidizing step 36, and a deposition step 38. As an example, the article 10 may initially include only the substrate 12 and the unoxidized bond coat 16. The heating step 32 may include heating the article 10 in an atmosphere that is substantially free of oxygen to an oxidation temperature that is within a predetermined temperature range. For instance, the atmosphere may be a low pressure atmosphere of about 1 x 10⁻⁴ - 1 x 10⁻² torr (0.013 - 1.33 pascals). Such a pressure range may be considered to be substantially free of oxygen.

The predetermined temperature range may be about 1800°F (982°C) - 2050°F (1121°C). The type of alumina that is desired determines the minimum temperature, and the type of material selected for the substrate 12 determines the maximum temperature. In this case, alpha-alumina forms preferentially over other types of alumina at temperatures above about 1800°F. Temperatures above about 2050°F may negatively influence common types of superalloys that may be used for the substrate 12. The maximum temperature may increase as new superalloys having greater thermal stability are developed.

After heating to the desired oxidation temperature, a selected partial pressure of oxygen is established within the atmosphere in the pressurizing step 34. An operator, automatic controller, or the like may feed a controlled amount or flow rate of oxygen into the atmosphere surrounding the article 10 such that the atmosphere increases to a predetermined pressure. For instance, the pressure may be no greater than 0.1 torr (13.3 pascals). In a further example, the pressure may be with a pressure range of 5 x 10⁻⁴ - 1 x 10⁻² torr (0.067 - 1.33 pascals).

The oxygen in combination with the oxidation temperature causes at least a portion of the bond coat 16 to oxidize in the oxidizing step 36. At the given oxidation temperature of 1800°F (982°C) - 2050°F (1121°C) and given pressure of no greater than 0.1 torr (13.3 pascals), the alpha-alumina 18 preferentially forms over other types of alumina. Moreover, these conditions are not favorable for the formation of other types of alumina and therefore the alpha alumina 18 forms to the substantial exclusion of the other types of alumina.

The article 10 oxidation temperature and pressure may be maintained for a predetermined amount of time to establish a desired thickness of the alpha-alumina 18. As an example, the time may be fifteen minutes or less. Given this description, one of ordinary skill in the art will recognize suitable times to meet the needs of their particular application.

After the oxidizing step 36, the article 10 is coated with the ceramic coating 14 in the deposition step 38. As an example, electron beam physical vapor deposition may be used to deposit the ceramic coating 14. The method 30 may alternatively utilize other types of deposition processes, such as plasma spraying or cathodic-arc.

Figure 3 illustrates an example coating device 50 for implementation of the method 30. In this example, the coating device 50 includes a heating chamber 52 and a coating chamber 54. The heating chamber 52 may include graphite heating elements 56 for heating the article 10 to the oxidation temperature. The coating chamber 54 may include a coating zone 58 where the article 10 is coated with the ceramic coating 14. A crucible 60 containing a source coating material 62 may be arranged below the coating zone 58 at a desired stand-off distance.

An electron beam source 64 may be mounted relative to the coating chamber 54 for directing electron beams 66 toward the source coating material 62 to coat the article 10 in a known manner. A gate seal 68 may be arranged between the heating chamber 52 and the coating chamber 54 to seal the atmospheres of each chamber from each other.

A transport 70 for moving one or more of the articles 10 may include a shaft 72 for mounting the articles 10 in the coating device 50. The transport 70 selectively extends and retracts the shaft 72 to move the article 10 between the heating chamber 52 and the coating chamber 54. In this regard, a controller (not shown) may be used to control the operation of the transport 70, gate seal 68, electron beam source 64, and other components of the coating device 50.

An oxygen gas source 74 may be connected with the heating chamber 52 to selectively feed oxygen gas to the interior of the heating chamber 52. A valve 76 may be provided to control the gas flow. Additionally, or alternatively to the oxygen gas source 74, an oxygen gas source 78 may be connected with the coating chamber 54 to feed oxygen to the interior of the coating chamber 54. Likewise, a valve 80 may be provided to control the gas flow. The coating device 50 may also include other components that are not shown, such as a cooling system to maintain the walls of the device at a desired temperature.

In operation, the graphite heating elements 56 may be used to heat the article 10 to the oxidation temperature. A vacuum pump (not shown) or other such device may evacuate the interior of the heating chamber 52 to the desired low pressure. Once the oxidation temperature is established, the valve 76 may be opened to supply oxygen from the oxygen gas source 74 into the interior of the heating chamber 52 to establish the partial pressure of oxygen. The article 10 may reside in the heating chamber 52 for a predetermined amount of time to form the alpha-alumina 18. The gate seal 68 may then be opened for the transport 70 to move the article 10 into the coating chamber 54 for depositing the ceramic coating 14.

Alternatively, instead of supplying the oxygen from the oxygen gas source 74, the gate seal 68 may be opened to let oxygen from the coating chamber 54 into the heating chamber 52 to establish the partial pressure of oxygen. In this regard, the oxygen gas source 74 may not be used.

In another alternative, the gate seal 68 may be opened after establishing the oxidation temperature and the transport 70 may move the article 10 into the coating chamber 54. Prior to depositing the ceramic coating 14, the valve 80 may be opened to feed oxygen gas into the interior of the coating chamber 54 to thereby establish the partial pressure of oxygen.

In the disclosed examples, the method 30 provides the benefit of forming a desired type of thermally grown alumina on the bond coat 16. Additionally, the relatively small amount of oxygen and short oxidizing time used to form the alumina is not significantly detrimental to the components of the coating device 50. For instance, the graphite of the graphite heating elements 56 readily oxidizes in the presence of oxygen at the processing temperatures used in the method 30. However, the low pressures of oxygen used in the method 30 and short exposure time substantially limits or prevents oxidation of the graphite. Therefore, the method 30 provides the benefit of preferentially forming the alpha-alumina 18 without harming the graphite heating elements 56.

Although a combination of features is shown in the illustrated examples, not all of them need to be combined to realize the benefits of various embodiments of this disclosure. In other words, a system designed according to an embodiment of this disclosure will not necessarily include all of the features shown in any one of the Figures or all of the portions schematically shown in the Figures. Moreover, selected features of one example embodiment may be combined with selected features of other example embodiments.

The preceding description is exemplary rather than limiting in nature. Variations and modifications to the disclosed examples may become apparent to those skilled in the art, and therefore the scope of legal protection given to this disclosure can only be determined by studying the following claims.

## Claims

1. A method of processing an article, comprising:
heating an article (10) using graphite heating elements in a low pressure atmosphere that is substantially free of oxygen to an oxidation temperature above about 1800°F (982°C), the article including a substrate (12) and a bond coat (16) comprising MCrAlY disposed on the substrate, wherein the M is selected from a group consisting of cobalt, nickel, iron, and combinations thereof, the Cr is chromium, the Al is aluminum, and the Y is yttrium;
establishing a partial pressure of oxygen after heating to the oxidation temperature such that the low pressure atmosphere is at a pressure of no greater than 0.1 torr (13.3 pascals);
oxidizing at least a portion of the bond coat for a time of fifteen minutes or less in the partial pressure of oxygen at the oxidation temperature to form alpha-alumina to the substantial exclusion of forming other types of alumina; and
depositing a ceramic coating (14) on the oxide (18).

2. A method as claimed in claim 1, wherein the low pressure atmosphere is at a pressure of 1 x 10⁻⁴ - 1 x 10⁻² torr (0.013 - 1.33 pascals) during the heating of the article (10) to the oxidation temperature.

3. The method as claimed in claim 1 or 2, including depositing the ceramic coating (14) using an electron beam physical vapor deposition process.

4. The method as claimed in claim 1, 2 or 3, wherein establishing the partial pressure of oxygen includes opening a gate seal (68) between a heating chamber (52) in which the article is heated to the oxidation temperature and a coating chamber (54) in which the ceramic coating (14) is deposited to allow oxygen to flow from the coating chamber into the heating chamber.

5. A method as claimed in any preceding claim, wherein establishing the partial pressure of oxygen includes moving the article (10) from a heating chamber (52) in which the article is heated to the oxidation temperature into a coating chamber that includes oxygen.

6. A method as claimed in any preceding claim, wherein establishing the partial pressure of oxygen includes feeding oxygen gas from an oxygen gas source (74) into a chamber (52) in which the article is heated to the oxidation temperature.

## Patentansprüche

1. Verfahren zum Verarbeiten eines Artikels, umfassend:
Erhitzen eines Artikels (10) unter Verwendung von Graphit-Heizelementen in einer Niederdruckatmosphäre, die im Wesentlichen sauerstofffrei ist, auf eine Oxidationstemperatur über etwa 1800 °F (982 °C), wobei der Artikel ein Substrat (12) und eine Haftbeschichtung (16), welche auf dem Substrat abgeschiedenes MCrAlY umfasst, beinhaltet, wobei das M aus einer Gruppe bestehend aus Cobalt, Nickel, Eisen und Kombinationen daraus ausgewählt ist, das Cr Chrom ist, das Al Aluminium ist und das Y Yttrium ist;
Aufbauen eines Sauerstoff-Partialdrucks nach dem Erhitzen auf die Oxidationstemperatur, sodass die Niederdruckatmosphäre bei einem Druck von nicht mehr als 0,1 Torr (13,3 Pascal) erfolgt;
Oxidieren von zumindest einem Teil der Haftbeschichtung für einen Zeitraum von fünfzehn Minuten oder weniger in dem Sauerstoff-Partialdruck bei der Oxidationstemperatur, um alpha-Aluminiumoxid mit dem wesentlichen Ausschluss der Bildung anderer Arten von Aluminiumoxid zu bilden; und
Abscheiden einer Keramikbeschichtung (14) auf das Oxid (18).

2. Verfahren nach Anspruch 1, wobei die Niederdruckatmosphäre bei einem Druck von 1 x 10⁻⁴ - 1 x 10⁻² Torr (0,013-1,33 Pascal) während des Erhitzens des Artikels (10) auf die Oxidationstemperatur erfolgt.

3. Verfahren nach Anspruch 1 oder 2, beinhaltend das Abscheiden der Keramikbeschichtung (14) unter Verwendung eines Elektronenstrahl-Gasphasenabscheidungsprozesses.

4. Verfahren nach Anspruch 1, 2 oder 3, wobei das Aufbauen des Sauerstoff-Partialdrucks das Öffnen einer Gate-Abdichtung (68) zwischen einer Heizkammer (52), in welcher der Artikel auf die Oxidationstemperatur erhitzt wird, und einer Beschichtungskammer (54), in welcher die Keramikbeschichtung (14) abgeschieden wird, beinhaltet, damit Sauerstoff von der Beschichtungskammer in die Heizkammer strömen kann.

5. Verfahren nach einem der vorausgehenden Ansprüche, wobei das Aufbauen des Sauerstoff-Partialdrucks das Bewegen des Artikels (10) von einer Heizkammer (52), in welcher der Artikel auf die Oxidationstemperatur erhitzt wird, in eine Sauerstoff enthaltende Beschichtungskammer beinhaltet.

6. Verfahren nach einem der vorausgehenden Ansprüche, wobei das Aufbauen des Sauerstoff-Partialdrucks das Zuführen von Sauerstoffgas aus einer Sauerstoffgasquelle (74) in eine Kammer (52), in welcher der Artikel auf die Oxidationstemperatur erhitzt wird, beinhaltet.

## Revendications

1. Procédé de traitement d'un article, comprenant :
le chauffage d'un article (10) à l'aide d'éléments chauffants en graphite dans une atmosphère basse pression qui est sensiblement dépourvue d'oxygène jusqu'à une température d'oxydation au-dessus d'environ 982 °C (1 800 °F), l'article comportant un substrat (12) et une couche de liaison (16) comprenant du MCrAlY disposée sur le substrat, dans lequel le M est choisi dans un groupe constitué de cobalt, de nickel, de fer, et de leurs combinaisons, le Cr est le chrome, l'Al est l'aluminium, et l'Y est l'yttrium ;
l'établissement d'une pression partielle d'oxygène après chauffage jusqu'à la température d'oxydation de sorte que l'atmosphère basse pression soit à une pression non supérieure à 0,1 torr (13,3 pascals) ;
l'oxydation d'au moins une portion de la couche de liaison pendant une durée de quinze minutes ou moins dans la pression partielle d'oxygène à la température d'oxydation pour former une alpha-alumine à l'exclusion sensible d'une formation d'autres types d'alumine ; et
le dépôt d'un revêtement en céramique (14) sur l'oxyde (18).

2. Procédé selon la revendication 1, dans lequel l'atmosphère basse pression est à une pression de 1 x 10⁻⁴ - 1 x 10⁻² torr (0,013 à 1,33 pascal) pendant le chauffage de l'article (10) jusqu'à la température d'oxydation.

3. Procédé selon la revendication 1 ou 2, comportant le dépôt du revêtement en céramique (14) à l'aide d'un processus de dépôt physique en phase vapeur par faisceau d'électrons.

4. Procédé selon la revendication 1, 2 ou 3, dans lequel l'établissement de la pression partielle d'oxygène comporte l'ouverture d'un joint de grille (68) entre une chambre chauffante (52) dans laquelle l'article est chauffé jusqu'à la température d'oxydation et une chambre de revêtement (54) dans laquelle le revêtement en céramique (14) est déposé pour permettre à l'oxygène de s'écouler de la chambre de revêtement jusque dans la chambre chauffante.

5. Procédé selon une quelconque revendication précédente, dans lequel l'établissement de la pression partielle d'oxygène comporte le déplacement de l'article (10) d'une chambre chauffante (52) dans laquelle l'article est chauffé jusqu'à la température d'oxydation jusque dans une chambre de revêtement qui comporte de l'oxygène.

6. Procédé selon une quelconque revendication précédente, dans lequel l'établissement de la pression partielle d'oxygène comporte l'apport de gaz oxygène provenant d'une source de gaz oxygène (74) dans une chambre (52) dans laquelle l'article est chauffé jusqu'à la température d'oxydation.
